# EUROPÄISCHE PATENTSCHRIFT

(11) **EP 0 587 845 B1**
(45) Veröffentlichungstag und Bekanntmachung des Hinweises auf die Patenterteilung: **05.06.1996**
(21) Anmeldenummer: 93906442.4
(22) Anmeldetag: 25.03.1993
(51) Int. Cl.: H01L 21/00

(54) **EINRICHTUNG UND VERFAHREN ZUR HANDHABUNG VON GEGENSTÄNDEN**
DEVICE AND METHOD FOR HANDLING OBJECTS
INSTALLATION ET PROCEDE PERMETTANT LA MANIPULATION D'OBJETS

(30) Priorität: 02.04.1992 DE 4210960
(43) Veröffentlichungstag der Anmeldung: 23.03.1994
(73) Patentinhaber: INTERNATIONAL BUSINESS MACHINES CORPORATION, Armonk, N.Y. 10504 (US)
(72) Erfinder: SWOBODA, Bruno, D-6500 Mainz (DE); SCHWARZE, Jürgen, D-6501 Saulheim (DE); WILD, Ingo, D-6500 Mainz (DE)
(74) Vertreter: Schäfer, Wolfgang, Dipl.-Ing.
(86) Internationale Anmeldenummer: DE9300274
(87) Internationale Veröffentlichungsnummer: WO9320580

(56) Entgegenhaltungen:
- EP-A- 0 273 791
- EP-A- 0 335 752
- US-A- 5 058 491

## Beschreibung

Die vorliegende Erfindung betrifft eine Reinrauminsel zum Fertigen von Gegenständen, insbesondere Halbleiter, Speicherplatten, Medikamente, pharmazeutische Artikel, Lebensmittel, etc. und ein Verfahren zur reinraumgerechten Handhabung von in Behälter gelagerten Gegenständen, die bei der Herstellung Reinraumbedingungen erfordern.

Zur Herstellung und Bearbeitung verschiedener Gegenstände, wie z. B. Halbleiter, Medikamente, pharmazeutische Artikel und dergleichen ist erforderlich, daß dies in einer möglichst sauberen Umgebungsluft erfolgt. Dazu wurden in der Technik verschiedene Reinraumklassen definiert, die jeweils bestimmte Partikelgrößen und -menge zulassen. Dies beginnt mit der Reinraumklasse 10000 als schlechteste Klasse und endet mit der Klasse 0,01 als beste. Dazwischen liegen die Klassen 1000, 100, 10, 1, 0,1. Um nun eine Reinraumklasse zu erhalten, ist ein enormer apparativer Aufwand erforderlich. Dazu kommt, daß, selbst wenn die Geräte eine ausreichende Reinraumklasse gewährleisten, die Gegenstände durch diese handhabende Personen sehr schnell wieder verschmutzen werden. Der Aufwand von Klasse zu Klasse steigt mehr und mehr und führt dazu, daß verschiedentlich Anlagen konzipiert wurden, bei denen die bedienenden Personen in raumfahrerähnlichen Anzügen mit einer Luftversorgung verbunden sind, damit jeglicher Kontakt der bedienenden Personen mit den zu bearbeitenden Gegenständen vermieden wird.

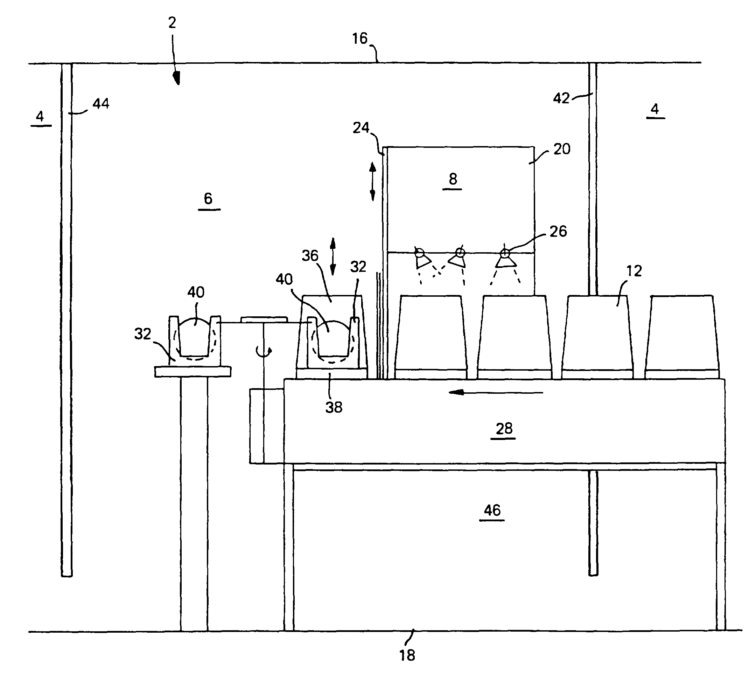

Eine Verbesserung in dieser Hinsicht brachte das sogenannte SMIF-Konzept (Standard Mechanical Interface) der Firma ASYIST, wie es in der Zeitschrift Solid State Technology, Juli 1984, Seite 111 und in den US-PS 4 995 430, 4 974 166, 4 859 137, 4 815 912, 4 739 882, 4 724 874, 4 674 936, 4 676 709, 4 674 939 und den EP OS 292235, 288455 beschrieben ist. Die beanspruchten Gegenstände dieser Veröffentlichungen beziehen sich auf einzelne Teile dieses Konzepts. Das Wesentliche diese Konzepts ist, daß die in Reinraumumgebung zu bearbeitenden Gegenstände, in diesem Fall Halbleiterscheiben, in einer Reinraumumgebung prozessiert und in dieser Reinraumumgebung in Behälter verschlossen werden. Diese Behälter können eine gewisse Reinraumklasse aufrechterhalten, wobei es jedoch auch spezielle, sogenannte aktive Behälter gibt, die zusätzlich die Luft in den Behältern filtern und somit auf einem bestimmten höheren Reinraumniveau halten können. Diese Behälter werden dann von den bedienenden Personen zu einer anderen Prozeßstation gebracht. Der Bereich, in dem sich die Bedienungspersonen aufhalten, weist zwangsläufig eine schlechtere Reinraumklasse auf. Die Behälter werden dann in ein eigens dafür konstruiertes Schnittstellengerät eingesetzt, das den Behälter in einer bestimmten Art und Weise von unten öffnet, um zu verhindern, daß die Schmutzpartikel, die sich durch den Transport auf der Außenfläche des Behälters abgesetzt haben, beim Öffnen mit den Gegenständen in Berührung kommen oder in den Reinraumbereich gelangen können. Von diesem Gerät aus gelangen dann die Gegenstände (Halbleiterscheiben) in den Reinraum, in dem die weitere Prozessierung erfolgen soll. Dieses Konzept hat den Nachteil, daß es relativ große Reinraumflächen mit einer hohen Reinraumqualität und zusätzlich eine genau auf die Schnittstelleneinrichtung abgestimmte Reinraumkonzeption und Behälterausgestaltung erfordert. Das Konzept ist daher nicht universell für andere Gegenstände, wie z. B. Speicherplatten, Medikamente oder anderen Gegenständen anpassbar. Die DE-OS 38 26 925 offenbart eine Einrichtung zur Handhabung und Behandlung kontaminationsempfindlicher Gegenstände, wie Halbleiterteile oder ähnliche Produkte unter Reinraumbedingungen, die wenigstens einen Arbeitsflächen enthaltenden Reinraumbereich zur Behandlung der Gegenstände und einen Operatorbereich geringerer Reinheit aufweist, in dem die Gegenstände in Kassetten oder dergleichen untergebracht, gehandhabt und transportiert. In dem Operatorbereich ist wenigstens ein ortbewegliches Fahrzeug vorgesehen, das zumindest einen im wesentlichen geschlossenen Raum mit Mitteln zur geordneten Aufnahme eine Anzahl Kassetten aufweist, wobei in diesem Raum eine fahrzeugeigene Einrichtung zur dauerhaften Aufrechterhaltung von Reinraumbedingungen in dem die Kassetten aufnehmenden Raum des Fahrzeugs zugeordnet ist. In der Figur 1 und der diesbezüglichen Beschreibung werden großflächige Reinraumanlagen beschrieben, wobei mittels des besonders ausgestalteten Wagens die Produkte immer in Reinraumumgebung auch während des Transports gehalten werden sollen.

Aus der Zeitschrift "Reinraumtechnik", 1990, Heft 5, Seiten 40-43, ist bekannt, Produktoberflächen durch Ionisation zu schützen. Dabei wird die Oberfläche von Teilen durch entsprechend aufgeladene positive oder negative Luftionen neutralisiert. Der Artikel beschreibt, wie innerhalb möglichst kurzer Zeit die Partikelablagerungen auf Wafern für Partikel größer als 1 µm um den Faktor 16 reduziert werden können.

In dem US Patent 4 851 018 wird ein Wagen beschrieben, der Behälter aus einem Reinraumbereich übernehmen, in Reinraumatmosphäre transportieren und in einen weiteren Reinraumbereich übergeben kann. Auch dieser Wagen enthält aufwendige Einrichtungen zur Aufrechterhaltung der Reinraumbedingungen.

Der vorliegenden Erfindung liegt daher die Aufgabe zugrunde, eine Einrichtung und ein Verfahren anzugeben, das es ermöglicht, eine Reinraumfertigung aufzubauen, die universell auf beliebige Gegenstände anpassbar ist und mit möglichst geringem Flächenbedarf für Reinraumzonen mit hoher Reinraumqualität.

Diese Aufgabe wird für eine Reinrauminsel wie in den Patentansprüchen beansprucht gelöst. Danach weist die Reinrauminsel einen von der Umgebung abgeschirmten Reinraumbereich auf, innerhalb dessen ein Bearbeitungs-bereich und ein Reinigungsbereich vorgesehen sind. Der Reinraumbereich kann beispielsweise die Reinraumklasse 100 und darunter aufweisen, während die Umgebung die Reinraumklasse 10000 und darüber aufweist. Der Reinraumbereich hat eine um den Faktor 1000 bessere Reinraumklasse als die Umgebung. Sowohl der Bearbeitungs-bereich als auch der Reinigungsbereich sind so angeordnet, daß in jedem die für den Reinraumbereich erforderliche Reinraumklasse gewährleistet ist. In dem Bearbeitungs-bereich befinden sich Handhabungsgeräte und die Prozeßeinrichtungen, die für den in diesem Reinraumbereich vorgesehenen Prozeß erforderlich sind. Der Reinigungsbereich von der die Gegenstände und Reinigungseinrichtungen umgebenden Zone von dem Bearbeitungsbereich wenigstens hinsichtlich der umgebenden Atmosphäre getrennt, d. h., es soll sichergestellt werden, daß bei der Reinigung in dem Reinigungsbereich keine Schmutzpartikel in den Bearbeitungs-bereich gelangen können. Ferner ist in dem Reinigungsbereich zur Aufnahme von mindestens einem Behälter mit zubearbeitenden Gegenständen eine Aufnahmeeinrichtung vorgesehen, wobei der Behälter entweder maschinell oder von einer Bedienungsperson dort plaziert wird. Ferner befinden sich in dem Reinigungsbereich Reinigungseinrichtungen, die geeignet sind, mindestens einen Behälter mittels einem ionisierten Fluid von Schutzpartikeln zu reinigen. Derartige Reinigungseinrichtungen sind als Ionensprühdüsen für Luft oder auch Flüssigkeiten bekannt.

Die Reinigungseinrichtungen sind oberhalb der Aufnahmeeinrichtung angeordnet und sprühen ionisierte Luft auf mindestens einen Behälter. Die dann mit Partikeln verschmutzte Reinraumluft aus dem Reinigungsraum kann durch öffnungen in der Aufnahmeeinrichtung von unterhalb der Aufnahmeeinrichtung angeordneten Absaugeinrichtungen abgesaugt und der zentralen Luftreinigung für Reinräume zugeführt werden. Auf diese Art und Weise wird gewährleistet, daß die Schmutzpartikel gezielt aus dem Reinigungsbereich abgeführt werden und keine Verschmutzung möglicherweise der Reinraumluft im Bearbeitungsbereich folgen kann.

Der Reinigungsbereich kann als allseitig geschlossene Kammer ausgestaltet sein, jedoch hat es sich gezeigt, daß es ausreicht, wenn der Reinigungsbereich eine nach der dem Reinraumbereich abgewandte Trennwand zum Reinraumbereich aufweist. Damit kann der Behälter von der einen Seite auf der sich die Bedienungsperson befindet in den Reinigungsbereich eingebracht werden, und nach der Reinigung, nach öffnen der Trennwand in den Bearbeitungsbereich gebracht werden. Da die nach der Reinigung verschmutzte Reinraumluft im Reinigungsbereich (vor dem Öffnen der Trennwand) abgesaugt wird, stellt sich dann sehr schnell eine Reinraumbedingung ein, wie sie auch in dem Bearbeitungsbereich vorhanden ist. Ein Öffnen der Trennwand zur Übergabe des nun gereinigten Behälters in den Bearbeitungsbereich trägt nicht zur Verschmutzung des Bearbeitungsbereichs bei. Durch diese Anordnung ist es möglich, daß beliebige Arten von Behälter, deren Ausgestaltung sich nach den Gegenständen richtet, die prozessiert werden müssen, in den Reinraumbereich und dort insbesondere in den Bearbeitungsbereich eingeschleust werden können, ohne daß eine sonstige Anpassung erforderlich ist. Diese Einrichtung kann daher kostengünstig in jedem Fertigungsbereich und jeder Fertigungsindustrie; die dafür Bedarf hat, als Insellösung eingesetzt werden.

Zweckmäßigerweise ist als Aufnahmeeinrichtung ein Transportsystem vorgesehen, das den Transport von dem Reinigungsbereich in den Bearbeitungsbereich bewirkt. Das Transportsystem arbeitet beispielsweise nach dem Prinzip eines Hubbalkens. Dadurch sind die einzelnen transportierenden Elemente praktisch stationär in Transportrichtung und verbleiben somit immer in dem jeweiligen Bereich. Damit ist eine Partikelverschleppung ausgeschlossen und eine besondere Reinigung des Transportsystems nicht erforderlich. Dies unterstützt die automatische Fertigung, da das Transportsystem automatisch gesteuert nach dem Reinigen des Behälters und dem Öffnen der Trennwand zwischen dem Bearbeitungs-bereich und dem Reinigungsbereich, den gereinigten Behälter in den Bearbeitungsbereich transportiert, damit er dort von einem entsprechend geeigneten Handhabungsgerät aufgenommen werden kann. Aus Vereinfachungsgründen ist es vorteilhaft, daß das Transportsystem geradlinig verläuft, d. h. die bewegbare Trennwand ist der offenen Seite gegenüber angeordnet. Selbstverständlich kann es aus konstruktiven Gründen erforderlich sein ein anders angeordnetes Transportsystem vorzusehen, sowie darauf abgestimmt, eine andere zu öffnende Trennwand zwischen dem Reinigungs-und Bearbeitungsbereich. Das Handhabungsgerät kann dann nach der automatischen Identifizierung des Behälters den Behälter öffnen, die Gegenstände entnehmen und für einen nächsten Bearbeitungsschritt entsprechend anordnen. Nach der Bearbeitung werden die Gegenstände von dem Handhabungsgerät wieder in einem Behälter gelagert, verschlossen und für den Weitertransport aus dem Reinraumbereich heraus bereitgestellt.

Bei dem erfindungsgemäßen Verfahren zur reinraumgerechten Handhabung von Gegenständen, die bei der Herstellung Reinraumbedingungen erfordern, werden die folgenden Schritte ausgeführt:
- Zuerst werden die Gegenstände in einem ersten Reinraumbereich, der für die Bearbeitung erforderliche Reinraumklassen-Umgebung aufweist, bearbeitet.
- Anschließend in einen Behälter eingebracht und verschlossen, wobei dieser Behälter während des Transports die Reinraumklasse halten kann.
- Als nächstes werden die Behälter üblicherweise manuell oder auch maschinell zu einem weiteren Reinraumbereich transportiert. Dies kann über längere Strecken erfolgen, wobei üblicherweise der Bereich, durch den die Behälter transportiert werden, eine wesentlich schlechtere Reinraumklasse-Umgebung aufweist.
- Anschließend werden die Behälter in diesem weiteren Reinraumbereich plaziert, der die für den nächsten Bearbeitungsschritt erforderliche Reinraumumgebung aufweist.
- Nach dem Einbringen des Behälters in den weiteren Reinraumbereich erfolgt die Reinigung des Behälters von Schmutzpartikeln mittels ionisierter Luft und daran anschließend das öffnen des Behälters und Entnehmen der Gegenstände zur weiteren Bearbeitung.

Dieses Verfahren mit diesen einzelnen Schritten kann dann bei beliebig vielen weiteren Reinrauminseln angewandt werden. Bei der Reinigung des Behälters erfolgt der Luftfluß von oben nach unten über den Behälter.

Durch die erfindungsgemäße Einrichtung und das erfindungsgemäße Verfahren wird ein gesamtheitliches Konzept für ein komplettes Reinraumsystem geschaffen, daß das Produkt in Behältern kapselt, und von einem Reinraumbereich über einen Nicht-Reinraumbereich in einen Reinraum transportiert. Das ganze Konzept ist unabhängig vom Produkt, vom dazu passenden Behälter und von der Förderstrecke. Dies kann alles individuell angepasst werden, so daß eine Anwendung für beliebige Produkte möglich ist. Lokale Reinräume (Inseln) werden nur für den Produktverarbeitungsbereich aufgebaut und sind daher unabhängig vom restlichen Fertigungsbereich. Es ist damit ein Nachrüsten und Integrieren in vorhandene Fertigungslinien möglich.

Das vorstehend beschriebene Konzept und das Verfahren erlauben die kostengünstige Anwendung von Reinrauminseln in Produktionsbereichen jeglicher Art und stellen daher eine kostengünstige Alternative zu den bekannten Methoden für Einrichtungen des Standes der Technik dar.

Zum besseren Verständnis wird die Erfindung nachfolgend anhand eines Ausführungsbeispieles näher beschrieben. Die Zeichnungen stellen dar:
- Fig. 1: eine schematische Draufsicht auf einen lokalen Reinraumbereich mit einem Bearbeitungsbereich und einem Reinigungsbereich, zur Übergabe der Behälter vom geringeren Reinraumbereich zum höheren Reinraumbereich; und
- Fig. 2: einen schematischen Querschnitt durch einen lokalen Reinraumbereich mit Reinigungsbereich.

Fig. 1 zeigt einen lokalen Reinraumbereich 2 (Reinrauminsel), der hinsichtlich der gereinigten Luft von dem umgebenden Bereich 4 getrennt ist. Der Reinraumbereich 2 kann beispielsweise Luft der Reinraumklasse 100 und der umgebende Bereich Luft der Reinraumklasse 100000 enthalten. Bei dem Bereich 4 handelt es sich um den Fertigungsbereich, im dem sich üblicherweise Personen zur Bedienung und Wartung der verschiedenen Geräte aufhalten. Der Reinraumbereich 2 weist die für Reinraumbereiche übliche Einrichtungen zur Erhaltung einer derartigen Reinraumklasse auf. Diese beinhalten einen laminaren Luftstrom von oben nach unten, so daß Schmutzpartikel von dem umgebenden Bereich infolge des Überdrucks des Reinraudbereichs 2 nicht in diesen gelangen können, auch können Trennwände zwischen dem Reinraumbereich 2 und dem umgebenden Bereich 4 vorgesehen sein.

Um für diesen Zweck eine einwandfreie Luftführung zu gewährleisten, sind üblicherweise Leitwände (Schürzen) an den Decken 42, 44 angebracht, abhängig davon, in welcher Höhe die Bearbeitung des Produkts in dem Reinraumbereich erfolgen soll. Die Schürze 42 weist in dem Bereich des Transportsystems selbstverständlich eine Öffnung auf. Der Reinraumbereich 2 ist unterteilt in einen Bearbeitungsbereich 6 und einen Reinigungsbereich 8. In dem Bearbeitungsbereich 6 befindet sich beispielsweise ein automatisches Handhabungsgerät 10, das die zu bearbeitenden Gegenstände einem Behälter 12 entnimmt und einer Bearbeitungsmaschine 14 zuführt.

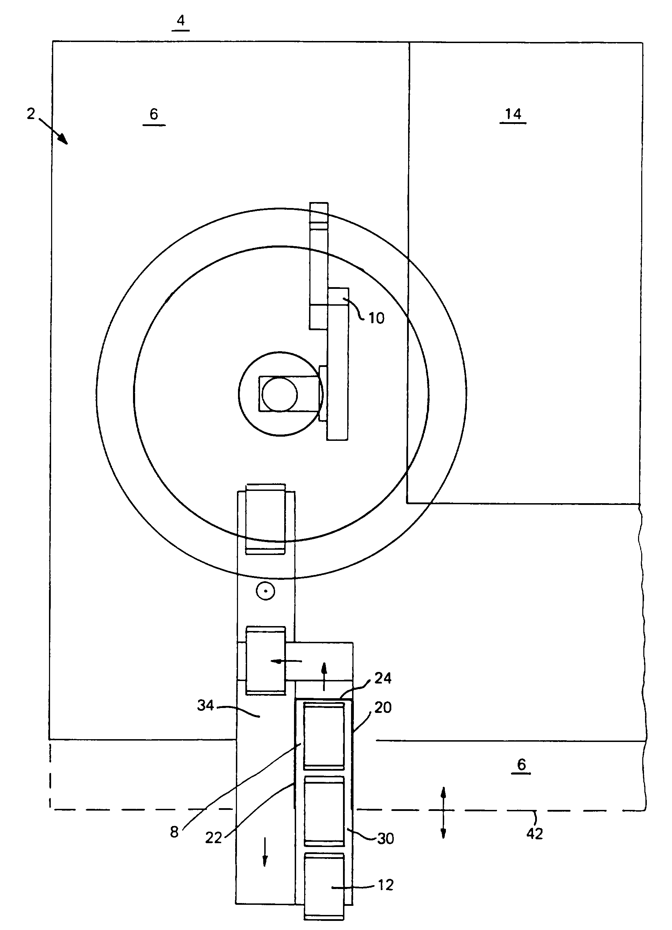

Der Reinigungsbereich 8 weist die dem Bearbeitungsbereich entsprechende Reinraumklasse auf, ist jedoch hinsichtlich der laminaren Luftströmung der Reinraumluft von der Decke 16 zum Boden 18 (Fig. 2) hin von dem Bearbeitungsbereich 6 getrennt. Im vorliegenden Ausführungsbeispiel ist der Reinigungsbereich 8 zu dem umgebenden Reinigungsbereich 4 geöffnet und weist lediglich zu dem Bearbeitungsbereich 6 hin Wände 20, 22, 24 auf, die verhindern, daß mit der Luftströmung Schmutzpartikel aus dem Reinigungsbereich 8 in den Bearbeitungsbereich 6 hineingelangen können. Während es sich in dem vorliegenden Ausfübrungsbeispiel bei den Wänden 20, 22 um feststehende Seitenwände handelt, ist die Wand 24 als bewegbare Trennwand ausgeführt, die den Transport von gereinigten Gehäusen 12 aus dem Reinigungsbereich 8 in den Bearbeitungsbereich 6 ermöglicht. Der Transport erfolgt beispielsweise. mittels eines Transportsystems, das erst einen Weitertransport ermöglicht, wenn die bewegbare Trennwand 24 geöffnet ist. In dem Reinigungsbereich 8 befinden sich oberhalb der Behälter 12 Ionendüsen 26, die negative und positive Ionen mittels eines gleichzeitig austretenden Druckluftstromes auf die Behälter 12 sprühen. Damit wird sowohl die elektrische Aufladung auf den Oberflächen der Behälter beseitigt als auch Staubkörnchen von der Oberfläche geblasen. Die nun verschmutzte Reinraumluft aus dem Reinigungsbereich 8 wird nach unten durch das Transportsystem 28 durch Öffnungen (nicht dargestellt) mittels einer Absaugeinrichtung 46 (schematisch dargestellt) abgesaugt und der Luft in den umgebenden Bereich 4 wieder zugeführt. Die bewegbare Trennwand 24 ist gegenüber dem umgebenden Bereich 4 zugewandten offenen Seite 30 angeordnet.

Wie bereits geschildert, wird der gereinigte Behälter 12 aus dem Reinigungsbereich 8 in den Bearbeitungsbereich 6 transportiert und dort mittels eines weiteren Handhabungsgeräts oder des Handhabungsgeräts 10 geöffnet und die zu bearbeitenden Gegenstände entnommen. Diese Gegenstände können auch noch auf einem weiteren Träger 32, angeordnet sein, der in einem Zwischenschritt zuerst dem Gehäuse 12 entnommen und dann in eine Position. gebracht wird, die es einem Handhabungsgerät 10 erlaubt, die in dem Träger 32 angeordneten Gegenstände einzeln der Bearbeitungsmaschine 14 zuzuführen.

In Fig. 2 ist ein Behälter 12 dargestellt, der einen Deckel 36 und ein Unterteil 38 aufweist, wobei das Unterteil 38 einen Träger 32 zur Aufnahme beispielsweise von Halbleiterscheiben 40 aufweist. Der Deckel 36 ist haubenförmig ausgebildet, so daß bei der Anhebung des Deckels 36 der Träger 32 zugänglich ist und auf diese Art und Weise der ganze Vorgang maschinell durchgeführt werden kann.

Entleerte oder bereits bearbeitete Gegenstände 40 enthaltende Behälter 12 können über ein zweites Transportsystem durch die Öffnung 34 aus dem Bearbeitungsbereich 6 in den umgebenden Bereich 4 befördert werden, um dann von dort manuell durch eine Bedienungsperson oder automatisch für die Weiterbearbeitung abgeholt werden zu können.

Die schematische Darstellung in Fig. 2 zeigt die Behälter 12, die bereits in den umgebenden Bereich 4 mit der wesentlich schlechteren Reinraumklasse auf dem Transportsystem abgestellt sind.

Mittels des Transportsystems 28 gelangen die Behälter 12 in den wesentlich besseren Reinraumbereich 2, der durch die von der Decke herabhängenden Schürzen 42, 44 getrennt ist und die dazu dienen, den gewünschten Luftstrom der sauberen Luft von der Decke 16 zum Boden 18 zu gewährleisten. In dem Reinraumbereich 2 befindet sich der Reinigungsbereich 8 mit den Ionendüsen 26 zum Abduschen der verschmutzten Behälter 12. Die Seitenwand 20 und die dargestellt Seitenwand 22 sowie die bewegbare Trennwand 24 trennen den Reinigungsbereich 8 hinsichtlich der Reinraumbedingungen von dem Bearbeitungsbereich 6. Im vorliegenden Ausführungsbeispiel ist die bewegbare Trennwand 24 als Schieber ausgebildet. In der Fig. 2 links neben der bewegbaren Trennwand 24 befindet sich ein bereits gereinigter Behälter 12, der in dieser Stellung geöffnet wird, um die Gegenstände 40 bzw. den Träger 32 aus dem Unterteil zu nehmen und zur weiteren Bearbeitung bereitzustellen. Beispielsweise kann das Handhabungsgerät ein Hub-/Drehlader sein, der den Träger entnimmt und diesen in eine Bearbeitungsposition bringt. Dabei wird gleichzeitig ein leergewordener Träger aus der Bearbeitungsposition entnommen, auf das Unterteil 38 abgestellt, der Deckel 36 abgesenkt und der Behälter verschlossen. Behälter mit leerem Träger werden dann durch die parallel angeordnete Förderstrecke herausgeführt.

Diese Einrichtung ermöglicht die reinraumgerechte Handhabung von Gegenständen jeglicher Art. Dazu werden die Gegenstände unter Reinraumbedingungen bearbeitet, anschließend in einen Behälter gegeben und dieser verschlossen. Der verschlossene Behälter, der in der Lage ist, die Reinraumbedingungen, die bei der Bearbeitung vorlagen, auch während des Transports aufrechtzuerhalten, wird dem Reinraumbereich entnommen und in den Bereich gebracht, der für die Weiterverarbeitung der Gegenstände vorgesehen ist. Damit keine Verunreinigungen in den Bearbeitungsbereich gelangen können, wird der Behälter in einem Reinigungsbereich, der bereits die Reinraumklasse des Bearbeitungsbereiches aufweist, gereinigt und anschließend dem Bearbeitungsbereich zugeführt. Während der Reinigung ist der Reinigungsbereich von dem Bearbeitungsbereich getrennt. Die Öffnung der Trennwand nach der Reinigung der Behälter erfolgt erst dann, wenn die verschmutzten Partikel nach unten abgesaugt sind, und sich in dem Reinigungsbereich wieder Reinraumbedingungen eingestellt haben, die denen des Bearbeitungsbereichs entsprechen. Die Wartezeit richtet sich nach der Luftleistung und der gesamten Reinraumanlage.

## Patentansprüche

1. Reinrauminsel zum Fertigen von Gegenständen (40), insbesondere Halbleiter, Speicherplatten, Medikamente, pharmazeutische Artikel, oder Lebensmittel, mit
wenigstens einem Reinraumbereich (2) mit einem gegenüber der Umgebung (4) um den Faktor 1000 besseren Reinraumklasse , der in
einen Bearbeitungsbereich (6) und einen davon trennbaren Reinigungsbereich (8) unterteilt ist,
mindestens einem Transportsystem (28) zum Transport von mindestens einem Behälter (12) mit zu bearbeiten Gegenständen zwischen dem Bearbeitungsbereich und der Umgebung,
Reinigungseinrichtungen (26) in dem Reinigungsbereich, die oberhalb des Transportsystems angeordnet und geeignet sind, mindestens einen Behälter mittels ionisierter Luft von Schmutzpartikeln zu reinigen, und einer unterhalb der Transportsystems angeordneten Absaugeinrichtung (46) zum Absaugen der verunreinigten Luft und vorzugsweisen Zuführung zur zentralen Luftreinigung für Reinräume.

2. Reinrauminsel nach Anspruch 1, in der der Reinigungsbereich nach der dem Reinraumbereich abgewandten Seite (30) hin offen ist und eine bewegbare Trennwand (24) zum Reinraumbereich aufweist.

3. Reinrauminsel nach Anspruch 2 bei dem die bewegbare Trennwand der offenen Seite gegenüber angeordnet ist.

4. Reinrauminsel nach einem der vorangegangenen Ansprüche mit einem computergesteuerten Handhabungsgerät (10) in dem Bearbeitungsbereich, das vorzugsweise die jeweils behandelten Gegenstände im Behälter identifiziert.

5. Verfahren zur reinraumgerechten Handhabung von in Behälter gelagerten Gegenständen, die bei der Herstellung Reinraumbedingungen erfordern, mit den folgenden Schritten
Bearbeiten der Gegenstände in einer ersten Reinrauminsel, mit der für die
Bearbeitung erforderliche Reinraumklassen-Umgebung,
Verschliessen der Gegenstände in dem Behälter, der diese Reinraumklasse während des Transports halten kann,
Transportieren dieses verschlossenen Behälters in einem Bereich mit einer um den Faktor 1000 schlechteren Reinraumklassen-Umgebung,
Plazieren dieses Behälters in einer weiteren Reinrauminsel mit einem Reinigungsbereich, der die für die Bearbeitung erforderliche Reinraumklasse aufweist,
Reinigen des Behälters von Schmutzpartikeln mittels ionisierter Luft, und Absaugen der verunreinigten Luft,
Wiederherstellung der für die Bearbeitung erforderlichen Reinraumklassen-Umgebung in dem Reinigungsbereich,
Transportieren des gereinigten Behälters direkt in den Bearbeitungsbereich, und
automatisches öffnen des Behälters und Entnehmen der Gegenstände zur weiteren Bearbeitung.

6. Verfahren nach Anspruch 5 bei dem die Reinigung durch einen Luftfluß von oben nach unten über den Behälter erfolgt.

7. Verfahren nach Anspruch 5 oder 6 bei dem automatisch der Behälter geöffnet, die Gegenstände entnommen und für einen nächsten Bearbeitungsschritt entsprechend angeordnet, und nach der Bearbeitung die Gegenstände wieder in einem Behälter gelagert, verschlossen und für den Weitertransport bereitgestellt werden.

## Claims

1. Clean-room island for the manufacture of objects (40), in particular semiconductors, memory boards, medicaments, pharmaceutical articles or foodstuffs with
at least one clean-room area (2) of a clean-room class better than that of the surrounding environment (4) by a factor of 1000, which is
divided into a working area (6) and a cleaning area (8) which can be separated from the working area,
at least one transport system (28) for the transportation of at least one receptacle (12) with objects for processing between said working area (6) and the surrounding environment (4)
cleaning equipment (26) in the cleaning area, aligned above the transport system and suitable for the cleaning of dirt particles from at least one receptacle by means of ionized air, and an extractor device (46) aligned underneath the transport system to suck out the contaminated air and preferably to feed the air to the central air cleaning plant for clean-rooms.

2. Clean-room island according to claim 1, wherein said cleaning area is open to the side (30) facing away from the clean-room area and has a moveable partition wall (24) separating it from the clean-room area.

3. Clean-room island according to claim 2, wherein said moveable partition wall is aligned opposite to the open side.

4. Clean-room island according to one of the above claims, with a computer-controlled handling appliance (10) in the working area, which preferably identifies the treated objects in the receptacles.

5. Method for clean-room handling of objects stored in a receptacle which require clean-room conditions in manufacture, with the following steps
Processing of the objects in an initial clean-room island with
the necessary class of clean-room environment for processing,
sealing of the objects in the receptacle, which is able to maintain this class of clean-room quality during transportation,
transportation of this sealed receptacle in an area of a clean-room class poorer by a factor of 1000 than that of the clean-room area,
placing of this receptacle in a second clean-room island with a cleaning area which is of the necessary clean-room class for the processing required,
cleaning of dirt particles from the receptacle by means of ionized air, and extraction of the contaminated air,
re-establishment of the necessary class of clean-room environment for processing in the cleaning area,
transportation of the cleaned receptacle directly into the working area, and
automatic opening of the receptacle and removal of the objects for further processing.

6. Method according to claim 5, wherein the cleaning is carried out by means of an air flow from top to bottom over the receptacle.

7. Method according to claim 5 or 6, wherein the receptacle is automatically opened, the objects removed and arranged appropriately for a subsequent processing stage, and after processing the objects are replaced in a receptacle, the receptacle sealed and made ready for onward transport.

## Revendications

1. Ilot de salle blanche pour la fabrication d'objets (40), notamment des semi-conducteurs, des cibles, des médicaments, des produits pharmaceutiques ou des denrées alimentaires avec
au moins une zone de salle blanche (2) possédant une classe de salle blanche 1000 fois meilleure que celle de l'environnement (4),
qui est divisée en une zone d'usinage (6) et une zone de nettoyage (8) que l'on peut séparer de celle-ci,
au moins un système de transport (28) destiné au transport d'au moins un conteneur (12) rempli d'objets à usiner, entre la zone d'usinage et l'environnement,
des installations de nettoyage (26) dans la zone de nettoyage agencées au-dessus du système de transport et capables d'éliminer les impuretés d'au moins un conteneur au moyen d'air ionisé et une installation d'aspiration (46) agencée sous le système de transport pour l'aspiration de l'air pollué et son évacuation préférentielle vers l'épuration d'air centrale des salles blanches.

2. Ilot de salle blanche selon la revendication 1, dans lequel la zone de nettoyage est ouverte du côté opposé à la zone de salle blanche (30) et présente une cloison mobile (24) permettant de l'isoler de la zone de salle blanche.

3. Ilot de salle blanche selon la revendication 2, dans lequel la cloison mobile est agencée face au côté ouvert.

4. Ilot de salle blanche selon l'une des revendications précédentes, avec un manipulateur (10) commandé par ordinateur dans la zone d'usinage, qui identifie de préférence les différents objets usinés dans le conteneur.

5. Procédé pour une manipulation conforme aux critères de salle blanche, des objets entreposés dans des conteneurs, qui exigent des conditions de salle blanche pour leur fabrication, comprenant les étapes suivantes
Usinage des objets dans un premier îlot de salle blanche, avec
L'environnement de classe de salle blanche nécessaire à l'usinage,
Verrouillage des objets dans le conteneur capable de satisfaire à cette classe de salle blanche pendant le transport,
Transport de ce conteneur verrouillé dans une zone dont l'environnement de salle blanche est 1000 fois plus mauvais,
Placement de ce conteneur dans un autre îlot de salle blanche avec une zone de nettoyage présentant la classe de salle blanche nécessaire à l'usinage,
Elimination des impuretés contenues dans le conteneur à l'aide d'air ionisé et aspiration de l'air pollué,
Restauration de l'environnement de salle blanche nécessaire à l'usinage dans la zone de nettoyage,
Transport direct du conteneur nettoyé dans la zone d'usinage et
Ouverture automatique du conteneur et prélèvement des objets pour la suite de l'usinage.

6. Procédé selon la revendication 5, au cours duquel le nettoyage est assuré par un flux d'air orienté de haut en bas au-dessus du conteneur.

7. Procédé selon la revendication 5 ou 6, au cours duquel le conteneur est automatiquement ouvert, les objets sont automatiquement prélevés et agencés en fonction de l'étape d'usinage suivante et où les objets sont à nouveau entreposés et enfermés dans le conteneur après usinage et tenus à disposition pour la poursuite du transport.
